Europäisches Patentamt

(19) European Patent Office

Office européen des brevets

(11) Publication number: **0 079 802**

**A1**

(12) # EUROPEAN PATENT APPLICATION

(21) Application number: **82306116.3**

(22) Date of filing: **17.11.82**

(51) Int. Cl.³: **C 25 D 17/12**

(30) Priority: **18.11.81 GB 8134749**

(43) Date of publication of application:
**25.05.83 Bulletin 83/21**

(84) Designated Contracting States:
**DE FR IT NL**

(71) Applicant: **Multicore Solders Limited
Maylands Avenue Hemel Hempstead
Hertfordshire HP2 7EP(GB)**

(72) Inventor: **Allen, Bernard Michael
8 Green End Road
Hemel Hempstead Hertfordshire, HP1 1QW(GB)**

(72) Inventor: **Morris-Browne, Raymond Alan
150 Lillington Road
Leamington Spa(GB)**

(72) Inventor: **Speck, Roger
27 The Greswoldes
Radford Semele Warwickshire(GB)**

(74) Representative: **Kosmin, Gerald Emmanuel et al,
HASELTINE, LAKE & CO. Hazlitt House 28 Southampton
Buildings Chancery Lane
London, WC2A 1AT(GB)**

(54) **Anodes for use in electroplating.**

(57) An anode assembly, suitable for use in solder plating, comprises a plurality of relatively short anode sections (2) mounted on a retaining rod (3) the upper end of which screws into a hook (6) by means of which the anode assembly is hung from a busbar when in use. The anode sections (2) are preferably of the same length, generally 0.20 metres, and can be made from a tin/lead alloy or from pure tin. This anode assembly avoids the conventional necessity of stocking anodes of various lengths and of having to discard a whole anode when only the lower end becomes too thin, and has the advantage that the central bore (10) present in each anode section can be of differing cross-section as an aid to identifying the material from which a particular anode section has been manufactured.

FIG.1.

- 1 -

## ANODES FOR USE IN ELECTROPLATING

This invention relates to the production of metallic coatings by the electrodeposition of a layer of a metal or alloy, such as solder, on an electrically conductive substrate and is concerned with a novel form of anode for use in the production of such coatings.

Solder anodes are used to electrodeposit a solder layer on, for example, printed circuit boards to protect the copper thereon and thereby extend the solderable shelf-life of the boards. They can also be used for plating copper wire or busbars, or for plating terminals, eyelets or other electronic parts. Such solder anodes are normally cast or extruded from tin/lead alloys, for example a 60/40 or 63/37 tin/lead solder alloy, and conventionally have either a flat rectangular cross-section, or a generally circular or elliptical cross-section. Similar anodes formed from other metals or alloys, for example tin or copper, are also used in plating processes. Commercially available solder anodes and tin anodes are supplied in various standard fixed lengths ranging from 18 to 42 inches (0.46 to 1.07 m) and may have one end drilled and tapped for insertion of a hook by which the anode is suspended from a busbar when in use. However, with the heavier anodes such a hook is unable to support the anode and it is necessary to solder a hook into the anode.

A disadvantage of such standard length solder and tin anodes is that since anodes of different lengths are required for particular plating baths, it is necessary for the manufacturer and/or user to keep in stock anodes of various lengths to meet the requirements of different solder plating baths. In the case of the longer anodes, these are not only very cumbrous but also take up much storage space. A further disadvantage of such anodes is that it is normal for the lower end of the anode to dissolve away more rapidly than the upper end, so that when the lower end becomes too thin, the whole anode has to be discarded.

It is an object of the present invention to provide an anode for use in electroplating processes which will obviate the disadvantages of the known standard length solder and tin anodes.

According to the invention there is provided an anode assembly comprising a plurality of relatively short anode sections, a longitudinally extending means for retaining the anode sections in a longitudinal disposition with one end of one anode section in contact with one end of the adjacent anode section, and hook means detachably attached to one end portion of said retaining means for suspending said anode assembly from a busbar when in use.

Each anode section may be formed from, for example, a tin/lead solder alloy, or pure tin.

The anode sections will advantageously all be of the same length, so that only one size of anode section need be kept in stock, and the desired length of anode for a particular electroplating bath can be obtained by selecting the appropriate number of anode sections to form the anode assembly. A further advantage is that when the lower end of the anode assembly dissolves away and becomes too thin, only the bottom anode section needs to be replaced by the addition of a fresh anode section.

In a preferred embodiment of the invention the retaining means for the anode sections can take the form of a rod having a length sufficient to accept the required number of anode sections, with the lower end of the rod having an enlarged section so as to retain the anode sections on the rod and the upper end of the rod being adapted to be affixed to an appropriate hook means. In this embodiment each anode section is formed with a longitudinal bore, either by casting, drilling or extrusion of the section, through which the retaining rod can be inserted when making up the anode assembly.

The anode sections may have any of the conventional cross-sectional shapes. However, it has been found that by producing the anode section with a cross-section in the shape of a dog-bone or dumb-bell, i.e. an anode section having bulbous edges, improved results are obtained.

For a better understanding of the invention and to show how the same may be carried into effect, reference will now be made, by way of example, to the accompanying drawing, in which:-

FIGURE 1 is a vertical cross-section through a solder anode assembly in accordance with the invention; and

FIGURE 2 is a horizontal cross-section through a preferred form of solder anode section in accordance with the invention.

Referring to the drawing, a solder anode assembly 1 comprises three identical anode sections 2 retained in a lengthwise disposition by a rod 3 having an enlarged lower end 4 on which rests a support washer 5. The upper end of the rod 3 is threadably engaged with a hook 6 by which the assembly is hung from a busbar when in use. A washer 7 may be positioned between the top end of the rod 3 and the hook 6. The rod 3, washers 5 and 7, and the hook 6 are preferably made from stainless steel so as to be inert in normal solder plating baths.

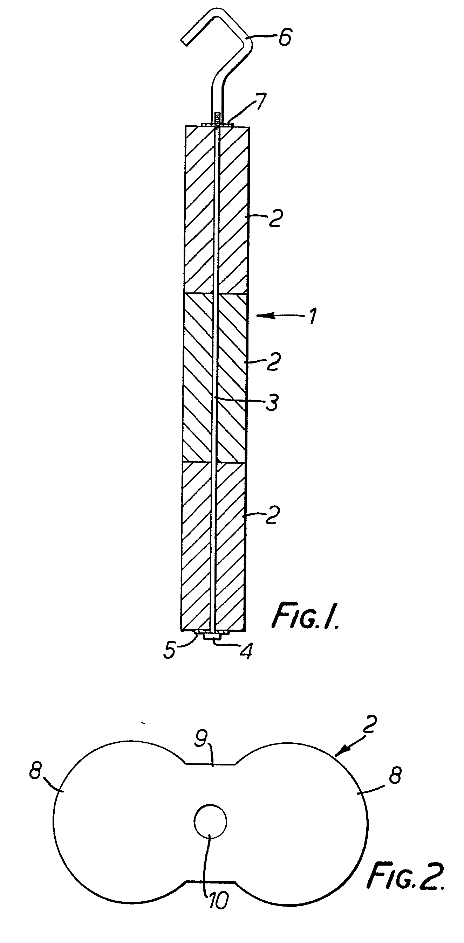

As shown in Figure 2, each anode section 2 has a generally dumb-bell cross-section comprising enlarged bulbous edge portions 8 joined by a short flat central portion 9. Each anode section 2 has a length of 8 inches (0.20 m) and is formed with a central bore 10 through which the retaining rod 3 can pass.

Although in the embodiment described with reference to the drawing, the central bore 10 is of circular cross-section, it will be appreciated that other cross-sectional shapes may be used, for example a square, hexagonal or triangular cross-section, and the use of such differently shaped central bores may advantageously be employed as an aid to identifying the material from which any particular anode section has been manufactured. This is of benefit when used anode sections are to be melted down as scrap in the manufacture of fresh anode sections. Likewise it will be appreciated that the anode assembly may comprise less or more than three anode sections, although generally not more than five anode sections are advantageously disposed on one retaining rod. The anode sections will generally be formed from pure tin or a 60/40 or 63/37 tin/lead solder alloy when used for solder plating.

CLAIMS:

1.      An anode assembly comprising a plurality of relatively short anode sections, a longitudinally extending means for retaining the anode sections in a longitudinal disposition with one end of one anode section in contact with one end of the adjacent anode section, and hook means detachably attached to one end portion of said retaining means for suspending said anode assembly from a busbar when in use.

2.      An anode assembly as claimed in Claim 1, wherein the longitudinally extending retaining means comprises a rod having an enlarged lower end capable of retaining the anode sections on the rod when in use and each anode section is formed with a longitudinal bore through which the retaining rod can be inserted.

3.      An anode assembly as claimed in Claim 1 or 2, wherein each anode section is formed from tin or a tin/lead solder alloy.

4.      An anode assembly as claimed in Claim 1, 2 or 3, wherein the anode sections are all of substantially the same length.

5.      An anode assembly as claimed in Claim 4, wherein each anode section has a length of 0.20 metres.

6.      An anode assembly as claimed in any preceding claim, wherein up to five anode sections are positioned on the retaining means.

0079802

6

7

2

1

2

3

2

5    4

Fig. I.

9        2

8        8

10

Fig. 2.

European Patent
Office

**EUROPEAN SEARCH REPORT**

**0079802**
Application number

EP 82 30 6116.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | US - A - 3 926 772 (L.G. CORDONE et al.)<br><br>* Fig. 2-4; claims *<br><br>-- | 1 | C 25 D 17/12 |
| Y | US - A - 3 915 835 (L.G. GORDONE et al.)<br><br>* Fig. 2-4; claims *<br><br>-- | 1 | |
| Y | US - A - 2 619 457 (F.W. WAGNER)<br><br>* Fig. 1; claims *<br><br>-- | 1,2,4, 5 | |
| Y | US - A - 2 504 238 (A. WESLEY)<br><br>* Fig. 1,2,4; claims *<br><br>---- | 1,2,4, 5 | |

TECHNICAL FIELDS
SEARCHED (Int. Cl. ³)

C 25 D

| X | The present search report has been drawn up for all claims | | |
|---|---|---|---|
| Place of search | Date of completion of the search | Examiner |
| VIENNA | 24-01-1983 | SLAMA |